# DEMANDE DE BREVET EUROPEEN

(11) **EP 1 226 930 A1**
(43) Date de publication de la demande: **31.07.2002**
(21) Numéro de dépôt: 01403019.1
(22) Date de dépôt: 26.11.2001
(51) Int. Cl.: B32B 7/04, B32B 15/08

(54) **Fabrication d'une bande métallique pour emballage comportant un revêtement constitué d'une couche métallique et d'un film de polymère, et bande obtenue**

(30) Priorité: 27.12.2000 FR 0017086
(71) Demandeur: USINOR, 92800 Puteaux (FR)
(72) Inventeur: Fousse, Daniel, 57050 Plappeville (FR)
(74) Mandataire: Lagrange, Jacques Etienne

(57) **Abrégé**

Procédé de fabrication d'une bande métallique revêtue pour emballage constituée d'une bande d'acier revêtue sur au moins une de ses faces d'un revêtement comportant, une sous-couche d'étain, et un film externe de polymère, selon lequel:
- d'une part, on dépose sur au moins une des faces de la bande d'acier une couche d'étain,
- d'autre part, on dépose une couche d'étain sous vide sur une face d'au moins un film de polymère,
- puis on approche l'au moins un film de polymère revêtu d'étain et la bande d'acier comportant au moins une couche d'étain de telle sorte que la face de l'au moins un film de polymère revêtu d'étain ou d'alliage à base d'étain soit en regard d'une face de la bande d'acier comportant une couche d'étain, en injectant entre lesdites faces un flux pour nettoyer les surfaces revêtues d'étain, et
- on soude l'au moins un film de polymère sur la face de la bande d'acier.

## Description

La présente invention est relative à un procédé de fabrication en continu de bandes métalliques, telles que des bandes d'acier, dont au moins une face est revêtue d'une sous-couche d'étain et d'une couche supérieure d'un revêtement organique.

L'invention s'applique en particulier à la fabrication de bandes d'acier pour emballage, telles que les boîtes alimentaires et les boîtes boisson.

Dans un des procédés connus de fabrication de ce type de bandes d'acier, l'acier est étamé électrolytiquement puis revêtu d'un revêtement organique par enduction d'un vernis soit au pinceau, soit au rouleau.

Après enduction, le vernis, composé essentiellement d'un polymère thermodurcissable et d'un solvant organique, subit une cuisson pour provoquer ou compléter la polymérisation et créer des liaisons étain-polymère qui permettent l'adhérence du vernis sur l'acier étamé. La difficulté réside dans le contrôle de la température de cuisson. En effet, en cas de sous-cuisson du vernis, on ne forme pas suffisamment de liaisons étain-polymère, ou bien elles restent hydrolysables (présence de liaisons hydrogène) et on risque de voir apparaître un décollement du vernis lors de la stérilisation des boîtes fabriquées avec ce type d'acier revêtu. En revanche, en cas de sur-cuisson, on observe une perte d'adhérence du vernis sur l'acier étamé et/ou une coloration (brunissement) du vernis.

Outre d'avoir à contrôler strictement la cuisson du vernis, ce procédé présente d'autres inconvénients mentionnés ci-après :
- il est indispensable de procéder à l'enduction du vernis en fine épaisseur afin de faciliter l'élimination totale du solvant organique, de l'eau et plus généralement des différents produits volatils de polymérisation ; ceci impose de procéder à des vernissages successifs de la bande d'acier étamée à des vitesse assez lentes de l'ordre de 100 m/min pour un vernissage en ligne, et 20 m/min pour un vernissage en feuille, pour obtenir une couche de vernis d'épaisseur suffisante ; généralement, on procède à l'enduction de deux à quatre couches de vernis pour obtenir une couche finale d'épaisseur de l'ordre de 8 à 25 µm.
- l'application successive de plusieurs couches de vernis nécessite de sous-cuire les premières couches pour éviter leur sur-cuisson lors du traitement thermique des couches ultérieures, ce qui dégraderait l'adhérence du revêtement et son aspect visuel ; ceci complique considérablement le contrôle de l'adhésion du vernis sur le substrat.
- actuellement, les réglementations environnementales imposent des normes de plus en plus restrictives visant à réduire l'utilisation des solvants organiques (VOC), voire à les supprimer, ce qui oblige les industriels à trouver des solutions de remplacement.
- le coût des vernis est très élevé et leur utilisation est limitée dans le temps en raison des problèmes de stockage qu'ils posent ; en effet, on risque lors du stockage d'observer une polymérisation partielle ou totale en pot rendant le vernis inutilisable.
- le coût de construction d'une ligne d'étamage est très élevé.

Dans un autre procédé, l'acier préalablement dégraissé, décapé et séché est étamé par un dépôt électrolytique d'étain, puis revêtu d'un film thermoplastique par collage du film sur la couche d'étain avec un adhésif.

Ce procédé comporte également des inconvénients. En effet, l'adhérence du polymère sur l'acier ou le fer blanc (acier revêtu d'étain ou encore acier étamé) n'est pas instantanée. Celle-ci est donc assez difficile à obtenir dans la fraction de seconde du contact, même si le polymère est fondu et chaud. En outre, la maîtrise d'une nappe fondue est un problème qui n'est pas encore résolu pour les polymères de type polyéthylène-téréphtalate PET. Par ailleurs, le collage, lui-même assez onéreux, impose l'élimination des solvants de la colle à travers le film polymère, ce qui n'est pas facile. Il est à noter, en outre, que la présence de la colle entre l'acier et le film de polymère est aisément détectable par la technique de l'infra-rouge.

La présente invention a donc pour but de proposer un procédé pour fabriquer en continu, et à des vitesses élevées, une bande d'acier dont au moins une face est revêtue d'une sous-couche d'étain et d'une couche supérieure d'un revêtement organique présentant une bonne adhérence au substrat, qui permet de mieux contrôler l'épaisseur de la couche organique par l'application en une seule fois d'une couche de polymère éventuellement très épaisse, et d'éviter l'utilisation de solvants organiques ou de colles.

A cet effet, l'invention a pour objet un procédé de fabrication d'une bande métallique revêtue pour emballage constituée d'une bande métallique mince revêtue sur au moins une de ses faces d'un revêtement comportant, dans l'ordre à partir de la surface de la bande métallique mince, une couche d'étain ou d'alliage à base d'étain, éventuellement une couche métallique intermédiaire, et une couche organique formée par un film de polymère, selon lequel :
- d'une part, on dépose sur au moins une des faces de la bande métallique mince une couche d'étain ou d'alliage à base d'étain en effectuant un décapage étamant ou un étamage,
- d'autre part, on dépose sous vide sur une face d'au moins un film de polymère au moins une couche métallique de façon à obtenir un film de polymère revêtu sur une face d'une couche externe d'étain ou d'alliage à base d'étain,
- puis on approche l'au moins un film de polymère revêtu et la bande métallique mince comportant au moins une couche d'étain ou d'alliage à base d'étain de telle sorte que la face de l'au moins un film de polymère revêtu d'étain ou d'alliage à base d'étain soit en regard d'une face de la bande métallique mince comportant une couche d'étain ou d'alliage à base d'étain, en injectant entre lesdites faces un flux pour nettoyer les surfaces revêtues d'une couche d'étain ou d'alliage à base d'étain, et
- on soude l'au moins un film de polymère sur la face de la bande métallique.

Le procédé selon l'invention peut comporter une ou plusieurs des caractéristiques suivantes :
- la bande métallique mince est en acier,
- l'au moins un film de polymère est revêtu sur une de ses faces d'abord par une couche intermédiaire d'aluminium ou d'alliage à base d'aluminium, puis d'une couche d'étain ou d'alliage à base d'étain,
- l'au moins un film de polymère est soudé sur la bande métallique mince par calandrage à chaud à une température comprise entre la température de fusion de l'étain ou de l'alliage à base d'étain et la température de fusion du polymère,
- pour effectuer le calandrage à chaud, on chauffe la bande métallique mince par induction ou conduction,
- le grammage de la couche d'étain sur la bande d'acier après le décapage étamant ou l'étamage est compris entre 0,05 et 1 g/m², de préférence entre 0,1 et 0,2 g/m²,
- le film de polymère est un film de polymère thermoplastique choisi de préférence parmi les PET, le PAN ou le PTFE, dont l'épaisseur est comprise entre 5 et 10 µm, de préférence entre 10 et 20 µm,
- le dépôt sous vide de la couche d'étain ou d'alliage à base d'étain sur le film de polymère est réalisé par PVD, et l'épaisseur de cette couche d'étain ou d'alliage à base d'étain est comprise entre 0,01 et 1 µm, de préférence entre 0,05 et 0,2 µm.
- le flux est réalisé par une aspersion d'alcool-rosine, d'acide phénolsulfonique ou d'acide chlorhydrique simultanément sur l'étain ou l'alliage à base d'étain revêtant la bande d'acier, et sur l'étain ou l'alliage à base d'étain revêtant le film de polymère.

L'invention a enfin pour objet une bande métallique revêtue pour emballage constituée d'une bande d'acier revêtue sur au moins une de ses faces d'un revêtement comportant, dans l'ordre à partir de la surface de la bande d'acier, une couche d'étain ou d'alliage à base d'étain, éventuellement une couche intermédiaire d'aluminium ou à base d'aluminium, et un film de polymère thermoplastique, sans trace de colle entre la couche d'étain ou d'alliage à base d'étain et le film de polymère thermoplastique.

Comme on l'aura compris, l'invention consiste à souder l'étain sur lui-même, à s'affranchir des problèmes de sous-cuisson ou de sur-cuisson inhérents aux polymères thermodurcissables composant les vernis, et à éviter l'utilisation de colle.

Ce procédé est applicable à tous les polymères, à condition que leur point de fusion soit supérieur à la température de fusion de l'étain (232 °C) ou de l'alliage à base d'étain, selon le cas.

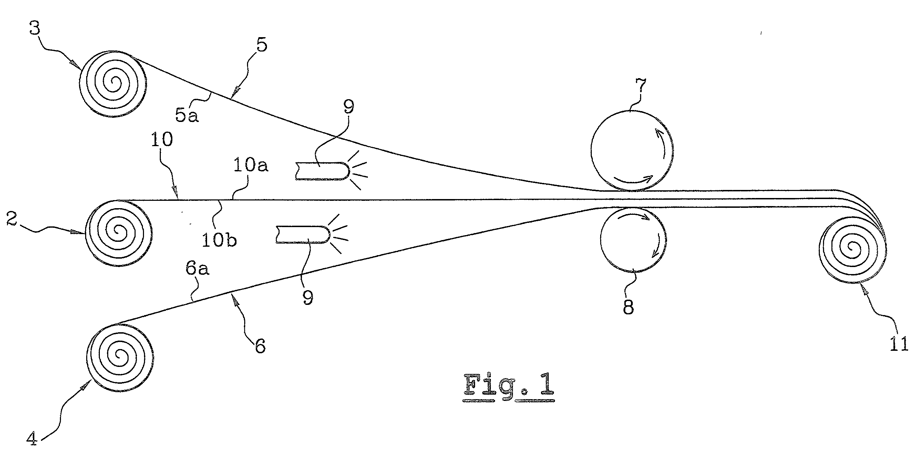

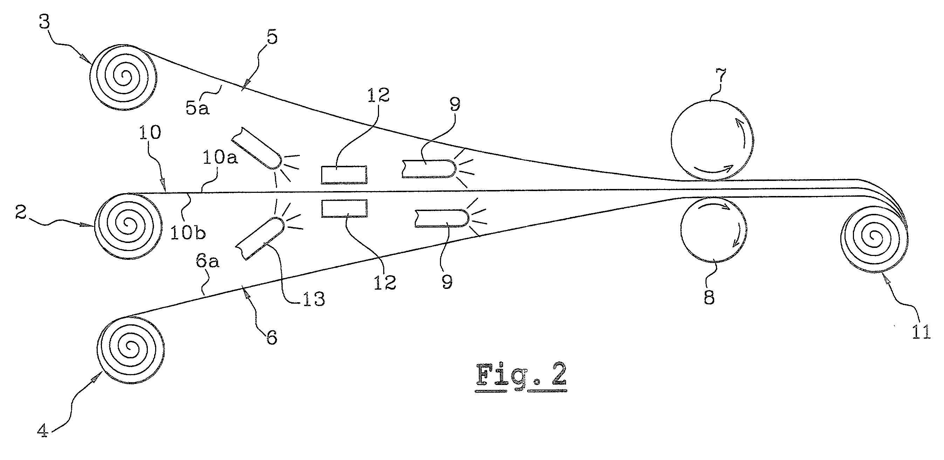

L'invention sera mieux comprise à la lecture de la description qui va suivre, donnée à titre non limitatif, et en référence à la figure 1 annexée qui est une vue schématique en élévation d'une partie d'une installation de fabrication d'une bande métallique pour emballage par calandrage à chaud, ainsi qu'à la figure 2 qui représente également une partie d'une installation de fabrication d'une bande métallique pour emballage par calandrage à chaud avec chauffage préalable de la bande par conduction ou par induction.

L'industrie de l'emballage est une grande consommatrice de tôles métalliques ou de bandes métalliques revêtues d'étain sur au moins une des faces, lesquelles sont protégées par un film d'un composé organique déposé soit par enduction, soit par collage d'un film organique. Dans le cas d'une utilisation de ce type de tôles dans le domaine alimentaire, il est impératif de veiller à ce qu'aucun composé nocif résiduel, comme les solvants organiques, ne soit présent, même à l'état de trace, dans le film organique. Il est donc nécessaire de contrôler strictement chaque étape de fabrication de ce type de tôle.

Après avoir été laminée à chaud, puis laminée à froid, la bande d'acier est dégraissée dans un bain alcalin chaud afin d'éliminer de la surface toutes traces d'huiles de laminage et de produits carbonés.

La bande ainsi dégraissée subit un décapage étamant dans une ligne de décapage électrochimique, dans un bain comprenant une solution aqueuse à base d'au moins un acide fort et d'un sel d'étain.

Le bain de décapage étamant peut également consister en un bain d'étamage dilué par un acide fort.

Le décapage étamant a deux actions :
- d'une part, la surface de l'acier est avivée par élimination des oxydes de fer formés lors des étapes précédentes de fabrication ;
- d'autre part, une couche très mince d'étain se dépose sur la surface avivée.

Les acides forts susceptibles d'être utilisés dans la présente invention sont choisis parmi : l'acide chlorhydrique, l'acide sulfurique, l'acide nitrique.

De préférence, les bains de décapage étamant sont constitués :
- soit d'un mélange d'acide chlorhydrique et de chlorure stanneux en solution aqueuse,
- soit d'un mélange d'acide sulfurique et de sulfate d'étain en solution aqueuse,
- soit d'un bain d'étamage dilué soit par de l'acide sulfurique, soit par un mélange d'acide sulfurique et d'acide phénolsulfonique.

Un bain d'étamage conventionnel est composé de sulfate d'étain, d'acide sulfurique, et d'additifs tels que des anti-oxydants et des brillanteurs choisis parmi l'acide phénolsulfonique (APS) ou l'éthoxy-naphtol sulfonique (ENSA).

L'acide est introduit dans le bain de manière à ce que la concentration équivalente en acide sulfurique soit comprise entre 10 et 100 g/l, de préférence entre 15 et 25 g/l.

En effet si le pH de la solution est trop acide (pH proche de zéro), un décapage trop important risque de se produire, gênant ainsi le dépôt d'étain.

En revanche, si le pH de la solution est supérieur à 1, l'acide ne sera pas assez puissant pour attaquer l'oxyde de fer recouvrant la surface de l'acier ; or l'étain ne se déposant pas et n'adhérant pas sur l'oxyde de fer, on n'observera pas le dépôt d'étain recherché.

Ainsi, le bain de décapage étamant comprend de 10 g/l à 100 g/l d'acide (exprimé en H₂SO₄ équivalent puisque, le plus souvent, plusieurs acides coexistent dans le bain), de préférence de 15 g/l à 25 g/l, et de 0,1 g/l à 1 g/l d'ion stanneux Sn²⁺, de préférence de 0,3 g/l à 0,5 g/l.

Enfin, le bain peut comprendre d'autres composants selon l'application visée, tels que des tensio-actifs, ainsi que des additifs conventionnels des solutions d'étamage comme l'acide phénol-sulfonique ou l'acide éthoxynaphtol-sulfonique (ENSA).

Pour obtenir un grammage d'étain sur la surface de la bande compris entre 0,05 et 1 g/m² (soit une couche d'épaisseur comprise entre 0,04 à 0,08 µm), de préférence entre 0,1 et 0,2 g/m² (soit une couche d'épaisseur comprise entre 0,008 à 0,02 µm), les conditions opératoires optimum sont les suivantes :
- vitesse de la bande : 300 à 600 m/min
- densité de courant adaptée à la vitesse de la bande
- temps de traitement : de l'ordre de 0,5 s
- température du bain : de l'ordre de 35 °C

Dans une variante de l'invention, la bande d'acier, préalablement décapée, peut subir un léger étamage dans les conditions d'une ligne d'étamage conventionnelle, de manière à la revêtir d'une couche d'étain dont le grammage est compris entre 0,05 et 8 g/m² (soit une couche d'épaisseur comprise entre 0,04 à 0,7 µm).

La bande d'acier, dont les deux faces ont été revêtues d'une fine couche d'étain, est rincée avec de l'eau par pulvérisation, par immersion ou par tout autre moyen, essorée puis séchée par exemple à l'air chaud pendant 0,5 à 2s.

Parallèlement à l'opération de décapage étamant de la bande d'acier, on réalise un dépôt sous vide d'une couche d'étain sur la surface d'au moins un film de polymère.

A titre représentatif des polymères susceptibles de constituer le film selon l'invention, on peut notamment citer tous ceux susceptibles de former des films comme :
- les polymères thermodurcissables tels que les époxy-phénoliques, ou les organosols,
- les polymères thermoplastiques tels que les polyéthylènes (PE), les polypropylènes (PP), les polyesters, le polyéthylène-téréphtalate (PET), le polyacrylonitrinile (PAN), les téflons (polytétrafluoroéthylène : PTFE).

Selon un mode préféré de l'invention, les polymères constituant le film sont des polymères thermoplastiques.

De préférence, les polymères thermoplastiques retenus sont le PET et le PAN ou le PTFE. En effet, ces polymères conservent de bonnes propriétés mécaniques à des températures élevées, notamment aux températures de l'ordre de 230 °C qui correspond au point de fusion de l'étain.

Le film thermoplastique est obtenu par extrusion du polymère thermoplastique, ou par laminage-couchage du polymère, de manière à obtenir des films dont la largeur peut varier entre 10 cm et 2 m voire plus, et dont l'épaisseur est uniforme et peut être fixée à volonté entre 5 et 100 µm voire plus, de préférence entre 10 et 20 µm.

Plus le film de polymère est épais, plus on améliore la résistance à la corrosion et à l'abrasion du corps ou du fond de boite fabriqués à partir du matériau réalisé selon l'invention. En effet, plus le film de polymère est épais, plus la perméabilité aux liquides et aux gaz, et la porosité sont faibles ; la protection des aliments ou des liquides contenus dans la boîte est ainsi mieux assurée.

Le film est ensuite revêtu sous vide d'un dépôt d'étain sur une de ses faces de manière à obtenir une couche d'étain uniforme d'épaisseur comprise entre 0,01 et 1 µm, de préférence entre 0,05 et 0,2 µm.

Le dépôt de l'étain sous vide sur le film de polymère peut être obtenu par l'une des techniques de revêtement sous vide connues en elles-mêmes telles que :
- PVD (Physical Vapour Deposition en langue anglaise)
- CVD (Chemical Vapour Deposition en langue anglaise)
- PECVD (Plasma Enhanced Chemical Vapour Deposition en langue anglaise)

On choisit de préférence la technique de revêtement par PVD, car celle-ci permet d'obtenir un dépôt métallique présentant une bonne adhérence au substrat de façon rapide et économique.

L'adhérence entre l'étain et le carbone du polymère est immédiate et directe en raison de la libération de l'énergie latente de vaporisation de l'étain lors du dépôt sous vide ; la liaison entre l'étain et le carbone présente en outre l'avantage d'être peu sensible à l'hydrolyse.

Selon une variante de l'invention, on peut réaliser un double dépôt métallique sous vide sur le film de polymère. Ainsi, préalablement au dépôt de la couche d'étain, on effectuera un dépôt d'une couche d'aluminium ou d'alliage à base d'aluminium sous vide sur le film. Cette couche d'aluminium ou d'alliage à base d'aluminium présente une bonne adhérence sur le polymère, et l'absence d'oxydes d'aluminium (on travaille sous vide, sans contact intermédiaire avec l'air) permet ensuite l'adhérence de l'étain sur l'aluminium ou sur l'alliage à base d'aluminium ; comme dans le cas précédent, la couche d'étain permet le soudage de l'ensemble sur acier étamé.

Le produit obtenu, qui consiste en un acier faiblement étamé revêtu sur au moins une de ses faces d'une fine couche d'aluminium ou d'alliage à base d'aluminium et d'un film externe de polymère, possède une meilleure résistance à la corrosion et à la sulfuration que le produit ne possédant pas de couche(s) intermédiaire(s) d'aluminium ou d'alliage à base d'aluminium entre l'étain et le film de polymère. Ce produit présente, en outre, un aspect de surface plus brillant.

Par ailleurs, malgré l'ajout d'une couche métallique supplémentaire, il garde un coût raisonnable.

Selon un mode de réalisation particulier de l'invention, on peut aussi réaliser un co-dépôt sous vide d'étain et d'un autre métal sur le film de polymère. On obtient ainsi un film de polymère revêtu d'une couche d'alliage étain-métal. Le choix de métaux comme l'indium, le plomb, le bismuth, le gallium et l'antimoine permet d'obtenir des alliages avec l'étain dont le point de fusion est considérablement abaissé par rapport au point de fusion de l'étain. Le choix des polymères utilisables devient alors beaucoup plus large : outre le PET, le PAN et le PTFE, on peut mettre en oeuvre des polymères dont le point de fusion est inférieur à 232 °C, et donc utiliser des polymères comme le polyéthylène ou le polypropylène. Cependant, en raison du type de métaux précédemment évoqué, la présence de tels alliages étain-métal n'assure pas la compatibilité avec des applications d'emballage de produits alimentaires des bandes revêtues par le procédé selon l'invention. On réservera donc ce type de bandes pour la fabrication d'emballage à usage non alimentaire, par exemple pour stocker des peintures ou des huiles.

Dans l'état actuel de la technologie, les vitesses de dépôt d'étain sous vide sur le film thermoplastique peuvent atteindre 1000 m/min

Nous allons maintenant décrire le procédé de fabrication d'un acier pour emballage selon l'invention en nous référant à la figure 1.

Dès que le film de polymère est revêtu d'étain sur l'une de ses faces, il est bobiné pour constituer des bobines 3,4, comme représentées sur la figure 1.

Sur la figure 1, on a représenté schématiquement une bobine 2 d'une bande d'acier 10 dont les deux faces 10a et 10b ont subi un décapage étamant, comme précédemment mentionné.

Ainsi, dans ce mode de réalisation, les deux faces 10a et 10b sont revêtues d'une couche d'étain.

Par ailleurs, sur cette figure, on a représenté deux bobines, respectivement 3 et 4, constituée chacune d'un film de polymère, respectivement 5 et 6 dont une face 5a et 6a a été préalablement revêtue d'une couche d'étain déposée sous vide.

Sur cette installation, on a représenté également deux cylindres de calandrage, respectivement 7 et 8 superposés et chauffés à une température déterminée, comme on le verra ultérieurement. Les cylindres 7 et 8 sont entraînés en rotation en sens inverse.

La face 5a du film en polymère 5 sur laquelle a été préalablement déposée une couche d'étain est destinée à être appliquée sur la face 10a de la bande d'acier 10 et la face 6a du film en polymère 6 préalablement revêtue d'une couche d'étain est destinée à être appliquée sur la face 10b de ladite bande d'acier 10.

Pour cela, les bobines 2, 3 et 4 sont dévidées simultanément et à la même vitesse pour appliquer les films de polymère 5 et 6 respectivement sur les faces 10a et 10b de la bande d'acier 10 de façon à introduire l'ensemble composite ainsi formé de la bande d'acier 10 et des deux films de polymère 5 et 6 entre les deux rouleaux 7 et 8 de calandrage.

Préalablement à la dépose des films de polymère 5 et 6 sur les faces 10a et 10b de la bande d'acier 10, on injecte dans l'espace ménagé entre chaque film de polymère 5 et 6 et la bande d'acier 10, un flux qui nettoie les surfaces étamées. Ce flux agit par élimination les oxydes d'étain qui se sont formés sur les faces 5a et 6a revêtues d'étain des films de polymère 5 et 6, et également sur les faces 10a et 10b revêtues d'étain de la bande d'acier 10. Pour cela, une rampe 9 d'injection de ce flux éliminant les oxydes d'étain est disposée dans chaque espace entre les films de polymère 5 et 6 et la bande d'acier 10, ainsi que représenté sur la figure 1.

Lors du passage de l'ensemble composite ainsi formé entre les cylindres 7 et 8 qui sont chauffés, les couches d'étain déposées sur les faces 5a et 6a des films de polymère 5 et 6 et sur les faces 10a et 10b de la bande d'acier 10 fondent ce qui permet d'obtenir le soudage de chaque film de polymère 5 et 6 sur la face correspondante de la bande d'acier 10. Le soudage de l'étain sur lui-même est instantané puisque les oxydes ont été éliminés. En outre, II n'est même pas nécessaire que les deux couches d'étain soient totalement fondues ; en effet, l'étain fondu mouille les îlots d'étain encore solide et on évite ainsi les dépôts pulvérulents.

A la sortie des rouleaux 7 et 8, l'ensemble composite peut s'enrouler pour former une bobine 11. Eventuellement, une trempe à l'eau permet de refroidir la surface plus rapidement.

Selon une variante, la bande d'acier 10 peut être revêtue sur une seule de ses faces par un film de polymère, de la même manière que celle précédemment mentionnée.

Dès que l'étain est en contact avec l'air, il s'oxyde et sa surface se couvre d'oxydes d'étain de type SnO et surtout SnO₂ rendant le soudage de l'étain impossible. Il convient donc de traiter ces oxydes d'étain par injection d'un flux qui les élimine par fusion ou dissolution, avant le passage des bandes 5, 6 et 10 entre les cylindres de calandrage 7 et 8.

A titre de flux susceptibles d'éliminer les oxydes d'étain, on utilise par exemple :
- des acides faibles en solution aqueuse (acide citrique) ou en solution alcoolique (alcool-rosine ou colophane),
- des acides en solution aqueuse utilisé conventionnellement comme flux pour la refusion du fer blanc (le fer blanc est la dénomination commune de l'acier étamé), tels que l'acide chlorhydrique ou l'acide phénol sulfonique,
- des produits fondants comme le chlorure de zinc en solution aqueuse.

On ajustera la concentration et le débit du flux en fonction du degré d'oxydation des surfaces étamées selon des méthodes connues en elles-mêmes.

La température de fusion de l'étain étant de 232°C, les films thermoplastiques sont choisis parmi les polymères dont la température de fusion est supérieure à cette température (c'est le cas notamment du PET qui résiste à une température de 250°C, et du PAN ou du PTFE qui résistent à 300°C).

Il pourra être utile de préchauffer la bande métallique, par induction ou par conduction, pour accélérer la montée en température, en particulier dans le cas où le dépôt du film polymère étamé est réalisé sur les deux faces de la bande étamée. En effet, le contact thermique se fait alors nécessairement à travers une couche de polymère, donc plus lentement ce qui serait incompatible avec une vitesse de ligne élevée.

La température des cylindres de calandrage est avantageusement comprise entre 235 et 250 °C, afin d'une part d'assurer la fusion de l'étain et de permettre aux couches d'étain de se souder l'une sur l'autre, et d'autre part de respecter les films thermoplastiques.

La vitesse de calandrage maximale est habituellement comprise entre 300 et 400 m/min, celle du décapage étamant peut atteindre 300 à 600 m/min. La bande métallique passant successivement dans le bac de décapage étamant avant de pénétrer dans la section de calandrage, celle- ci imposera donc en général sa vitesse. Comme nous l'avons déjà signalé, la vitesse de dépôt sous vide d'étain sur PET, opération totalement séparée peut dépasser 1000 m/min.

Selon une variante de l'invention représentée en figure 2, l'installation comporte des moyens 12 de chauffage de la bande d'acier 10, préalablement au soudage des films de polymère 5 et 6. Dans le cas du soudage du film de polymère 5, un moyen 12 de chauffage est disposé en regard de la face 10a de la bande métallique 10 et dans le cas du soudage du film de polymère 6, un moyen 12 de chauffage est disposé en regard de la face 10b de la bande métallique 10.

Lorsqu'un film de polymère 5 et 6 est soudé sur chaque face 10a et 10b de la bande métallique 10, un moyen de 12 de chauffage est placé en regard de chacune des faces 10a et 10b de ladite bande métallique 10.

Ce moyen 12 de chauffage est un moyen de chauffage par induction ou conduction dont la température est comprise entre 235 et 250 °C et a pour but de chauffer la bande d'acier 10 pour fondre la fine couche d'étain revêtant la ou les deux faces 10a et 10b de ladite bande 10.

Le ou les films de polymère 5 et 6 revêtus d'un dépôt mince d'étain 5a et 6a sur la bande 10 sont soudés par calandrage entre les rouleaux 7 et 8. Dans ce cas, le calandrage peut être effectué avec des cylindres à température ambiante, ou alors à une température largement inférieure à la température de fusion de l'étain. Par ailleurs, préalablement au chauffage de la bande d'acier étamée 10, les oxydes d'étain peuvent être avantageusement éliminés de la surface de ladite bande par un flux 13.

Le procédé selon l'invention permet ainsi de réaliser à des vitesses élevées des bandes d'acier revêtues sur les deux faces d'une sous-couche d'étain et sur au moins une face d'une couche externe d'un revêtement organique sur une ligne compacte de revêtement métallique et organique. Celle-ci consiste, comme on l'a vu, en des installations de dégraissage, de décapage étamant, de dépôt sous vide et de calandrage, lesquelles permettent de réaliser des bandes revêtues de grande largeur : films de polymère disponibles jusqu'à 2 m de large, dépôts sous vide effectués par creusets ou jets d'électrons non limités en nombre.

Lorsque la bande métallique et le film de polymère sont revêtus d'une couche d'alliage d'étain ayant un point de fusion inférieur à celui de l'étain, la température des cylindres de calandrage ou de préchauffage de la bande sont adaptés en conséquence.

Le précédé selon l'invention présente également d'autres avantages tels que :
- limitation des rejets polluants : pas d'utilisation de colle ou d'adhésif, pas d'émission de composés organiques volatiles, pas de gestion de bain d'étamage ; il suffit de traiter les résidus de fluxage chassés par pression lors du calandrage ;
- limitation des défauts de vernissage : en effet, les polymères thermoplastiques extrudés forment des films d'épaisseur régulière, pouvant dépasser 25 µm, et cela en une seule opération; ils ne sont pas sensibles aux sur-cuissons, sont souples et adhèrent bien à l'étain; les seuls défauts observés sont des inclusions de bulles d'air lorsque la vitesse de calandrage et/ou la rugosité de l'acier sont trop élevées ;
- les films thermoplastiques n'ont pas de limite de durée d'utilisation ;
- réduction des coûts : un polymère massif extrudé est beaucoup moins onéreux qu'un vernis usuel pour acier pour emballage de même épaisseur ;
- absence de pollution lors de l'incinération après utilisation des produits réalisés à partir des aciers obtenus selon le procédé : par exemple pour un PET, libération uniquement de gaz carbonique et d'eau ;
- possibilité de collage de PET sur du PET par simple chauffage si l'on souhaite par exemple réaliser une boîte trois pièces collées ;
- souplesse du revêtement polymère nettement plus grande; ceci permet une protection améliorée des zones ou le métal est fortement déformé comme le crochet de corps des boîtes souvent le lieu d'une corrosion notable ;
- brillance (réflectivité) de la bande d'acier revêtue selon l'invention supérieure à celle de l'acier étamé vernis selon l'art antérieur, dans le cas où le film de polymère thermoplastique est transparent (cas du PET par exemple).
- possibilité d'obtenir des aciers pour emballage très minces : en utilisant le procédé selon l'invention, il est possible de revêtir des bandes d'acier de très fine épaisseur, de l'ordre de 0,10 mm, alors qu'en utilisant les procédés de l'art antérieur, on ne peut revêtir, à l'heure actuelle, que des bandes d'acier dont l'épaisseur est ordinairement comprise entre 0,17 et 0,24 mm. En effet, la réalisation de fer blanc très mince est difficile sur une ligne d'étamage classique, en raison des tensions que subit le métal conduisant parfois à une rupture de la bande d'acier. Le procédé selon l'invention est réalisé sur des lignes beaucoup plus courtes, et de ce fait les tensions que subit la bande sont moins élevées. Par ailleurs, l'enduction simultanée de polymère peut être réalisée à des vitesses de l'ordre de 300 à 400 m/min, beaucoup plus faibles que les vitesses d'étamage usuelles. Le procédé selon l'invention reste néanmoins économique par rapport à un étamage à 400-600 m/min suivi d'un vernissage à 100-300 m/min.

Enfin la bande revêtue obtenue se distingue des bandes revêtues connues obtenues par collage d'un film de polymère, par le fait qu'aucune trace de colle ne peut être détectée.

## Revendications

1. Procédé de fabrication d'une bande métallique revêtue pour emballage constituée d'une bande métallique mince revêtue sur au moins une de ses faces d'un revêtement comportant, dans l'ordre à partir de la surface de la bande métallique mince, une couche d'étain ou d'alliage à base d'étain, éventuellement une couche métallique intermédiaire, et une couche organique formée par un film de polymère, selon lequel :
- d'une part, on dépose sur au moins une des faces de la bande métallique mince une couche d'étain ou d'alliage à base d'étain en effectuant un décapage étamant ou un étamage,
- d'autre part, on dépose sous vide sur une face d'au moins un film de polymère au moins une couche métallique de façon à obtenir un film de polymère revêtu sur une face d'une couche externe d'étain ou d'alliage à base d'étain,
- puis on approche l'au moins un film de polymère revêtu et la bande métallique mince comportant au moins une couche d'étain ou d'alliage à base d'étain de telle sorte que la face de l'au moins un film de polymère revêtu d'étain ou d'alliage à base d'étain soit en regard d'une face de la bande métallique mince comportant une couche d'étain ou d'alliage à base d'étain, en injectant entre lesdites faces un flux pour nettoyer les surfaces revêtues d'une couche d'étain ou d'alliage à base d'étain, et
- on soude l'au moins un film de polymère sur la face de la bande métallique.

2. Procédé selon la revendication 1, dans lequel la bande métallique mince est en acier.

3. Procédé selon l'une quelconque des revendications 1 ou 2, dans lequel au moins un film de polymère est revêtu sur une de ses faces d'abord par une couche intermédiaire d'aluminium ou d'alliage à base d'aluminium, puis d'une couche d'alliage d'étain ou à base d'étain.

4. Procédé selon l'une quelconque des revendications 1 ou 3, dans lequel l'au moins un film de polymère est soudé sur la bande métallique mince par calandrage à chaud, à une température comprise entre la température de fusion de l'étain ou de l'alliage à base d'étain et la température de fusion du polymère.

5. Procédé selon la revendication 4, dans lequel pour effectuer le calandrage à chaud, on chauffe la bande métallique mince par induction ou conduction

6. Procédé selon l'une quelconque des revendications 1 à 5, **caractérisé en ce que** le grammage de la couche d'étain sur la bande d'acier après le décapage étamant ou l'étamage est compris entre 0,05 et 1 g/m², de préférence entre 0,1 et 0,2 g/m².

7. Procédé selon l'une quelconque des revendications 1 à 6, **caractérisé en ce que** le film de polymère est un film de polymère thermoplastique choisi de préférence parmi les PET, le PAN ou le PTFE, dont l'épaisseur est comprise entre 5 et 100 µm, de préférence entre 10 et 20 µm.

8. Procédé selon l'une quelconque des revendications 1 à 7, **caractérisé en ce que** le dépôt sous vide de la couche d'étain ou d'alliage à base d'étain sur le film de polymère est réalisé par PVD, et **en ce que** l'épaisseur de ladite couche d'étain ou d'alliage à base d'étain est comprise entre 0,01 et 1 µm, de préférence entre 0,05 et 0,2 µm.

9. Procédé selon l'une quelconque des revendications 1 à 8, **caractérisé en ce que** le flux est réalisé par une aspersion d'alcool-rosine, d'acide phénolsulfonique ou d'acide chlorhydrique simultanément sur l'étain ou l'alliage à base d'étain revêtant la bande d'acier, et sur l'étain ou l'alliage à base d'étain revêtant le film de polymère.

10. Bande métallique revêtue pour emballage constituée d'une bande d'acier revêtue sur au moins une de ses faces d'un revêtement comportant, dans l'ordre à partir de la surface de la bande d'acier, une couche d'étain ou d'alliage à base d'étain, une couche intermédiaire d'aluminium ou à d'alliage base d'aluminium, et un film de polymère thermoplastique, et ne présentant aucune trace de colle entre la couche d'étain ou d'alliage à base d'étain et le film de polymère thermoplastique.
